# EUROPEAN PATENT SPECIFICATION

(11) **EP 1 777 529 B1**
(45) Date of publication and mention of the grant of the patent: **02.09.2009**
(21) Application number: 05255613.1
(22) Date of filing: 14.09.2005
(51) Int. Cl.: G01R 1/073, G01R 1/067

(54) **Electric signal connecting device and probe assembly using the same**
Elektrische Signalverbindungsvorrichtung und seine Verwendung in einer Testsondeneinrichtung
Dispositif de connexion de signaux électriques et carte à pointes l'utilisant

(43) Date of publication of application: 25.04.2007
(73) Proprietor: Kimoto, Gunsei, Minato-Ku, Tokyo (JP)
(72) Inventor: Kimoto, Gunsei, Minato-Ku, Tokyo (JP)
(74) Representative: Chettle, Adrian John

(56) References cited:
- EP-A- 0 802 419
- US-A1- 2003 067 315
- US-B1- 6 326 688
- US-B1- 6 330 744
- FAURE: "Modular Probe" IBM TECHNICAL DISCLOSURE BULLETIN, vol. 17, no. 6, November 1974 (1974-11), pages 1634-1634, XP002424548

## Description

### BACKGROUND OF INVENTION

### Field of the Invention

The present invention relates to an electric signal connecting device and a probe assembly for use in checking circuits in a plurality of semiconductor chips formed on a semiconductor wafer in the process of producing LSI and other electronic devices or in checking circuits in liquid crystal and other electronic devices. The present invention is used in the so-called probing test for, for example, measuring the electric conduction of semiconductor chips en bloc by bringing vertical probes into contact with circuit terminals (pads) arranged on the semiconductor chips while they are still in a wafer state.

### Description of Prior Art

The degree of integration of electronic devices has improved keeping pace with the progress in semiconductor technology, and the area occupied by circuit interconnection in each semiconductor chip formed on a semiconductor wafer keeps on increasing. As a result, the number of circuit terminals (pads) has increased on each semiconductor chip, and in keeping pace therewith the contraction of pad area, and the miniaturization of pad arrangement due to narrowing of pad pitch are progressing. At the same time, chip size packing of loading bare chips in circuit boards without enclosing semiconductor chips into package is becoming the main stream. For this reason, it becomes necessary by all means to check property and determine quality in the wafer state before dividing it into semiconductor chips.

In particular, an issue arising out of the miniaturization of pad arrangement (narrowing of pitch) is that the structure of probe for obtaining electric conductivity by bringing it into contact with the pads of semiconductor chips at the time of electric property tests or circuit test of electronic devices must be matched to the miniaturization of pad arrangement, and various measuring means are used to cope with this progress in miniaturization of pad arrangement.

For example, one of such means is one that makes a probe assembly made by area arranging a plurality of needle probes having a resiliently transforming part resiliently transforming in response to outside forces intervene between the pads of semiconductor chips to be tested and the testing device. As a means of electrically connecting this probe assembly and the test circuit of semiconductor chips, a printed wiring board called "probe card" is used. A past example of such circuit testing technology involving such a probe is, for example, the invention disclosed in the Japanese Patent Disclosure No. 2002-298297 and Japanese Patent Disclosure No. 2003-075503.

Generally in a probe card wherein a needle probe having a cantilever structure consisting of cantilever beams, the tip of probe coming into contact with the pad of semiconductor chips is narrow pitched, but in the base part in contact with the probe card, due to the radially expanding arrangement of the probe from the tip, a coarse pitch could be used and it was possible to fix probes to the circuit terminals of a probe card by soldering and similar connecting means. However, this cantilever structure had a problem of damaging the pads due to shifts in the horizontal direction of the tip that serve as the contact point when it comes into contact with the pad, or resulting in a fall in the measurement yield due to the tip falling off the pad. In addition, there were problems in that only a tip could be measured at a time and that the precision of fixing each probe varied resulting in a difficulty of controlling the contact pressure to a constant level.

In a vertical probe replacing this cantilever structure, in other words, in a vertical probe wherein the probe is fixed vertically to the circuit terminals of probe card, it is necessary that the pad pitch on a semiconductor chip and the circuit terminal pitch on a probe card have the same pitch interval. However, the miniaturization of circuit patterns on a probe card which is a printed wire board is limited by fabrication technology, and therefore, it is difficult for the area occupied by circuit terminals and wiring width to satisfy the requirements matching the pad pitch, and also because of a limit to the pitch interval for soldering, it was impossible to vertically fix a vertical probe to the probe card according to the pad pitch of the semiconductor chip as miniaturization progressed..

Thus, in a probe card the proportion of its plane area being occupied by the area of circuit terminals and the width of circuit interconnection is important and obstructs the narrowing of pitch of circuit terminals.
Accordingly, it was decided to adopt the means of maintaining the number of vertical probes by using a multilayered printed wiring board for the probe card, by arranging circuit terminals in a grid, in two lines or zigzag form and by electrically connecting the wiring between layers via through-holes. However, due to a large area represented by these through-holes, the presence of through-holes was an obstacle for narrowing the pitch of arranging circuit terminals. Thus, any attempt to fix vertical probes to a probe card was plagued by the difficulty of narrowing the pitch of circuit terminals and required an advanced technology in soldering and a large number of manual operations leading to high costs of manufacturing. In order to solve these problems, the inventors of the present invention propose a vertical probe assembly and have already proposed a probing device as an electric signal connecting device based on the use of such vertical probe assembly (see the Patent Reference 1 and the Patent Reference 2).

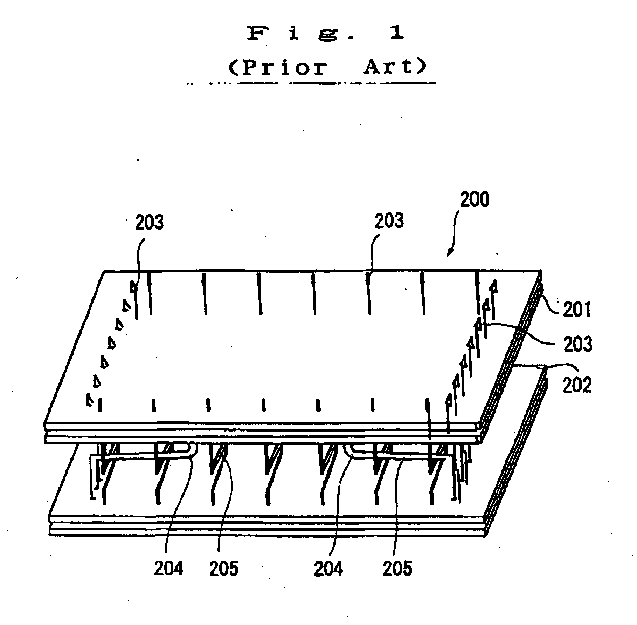

Fig. 1 is a perspective view showing a vertical probe assembly as a past example proposed by the inventors of the present invention. As the perspective view in Fig. 1 shows, this vertical probe assembly 200 already proposed (see, for example, the Patent Reference 1) consists of erecting a plurality of vertical probes 205 between two parallel upper and lower square insulating boards (or insulation films) 201 and 202. The two upper and lower insulating boards 201 and 202 are kept apart at a fixed interval being blocked by a stage in the middle of the vertical probe 205, and the pitch arrangement of vertical probes 205 is made to agree with the pitch arrangement of pads on the semiconductor chips to be tested. The upper and lower tips of each vertical probe 205 protrude slightly the insulating boards 201 and 202 and serve as electric contact terminals 203, and a curved part 204 is created in the intermediate part to provide resiliency against outside force applied on the probe in the vertical direction and to absorb distortions. At the same time, the deformation of the curved part 204 serves as the source of restoring force of spring, and this restoring force of spring turns into contact pressure between the top of the spring force probe and the pad to give electric conductivity. This curved part 204 is created at different vertical positions for each row so that the vertical probes 205 arranged at the right angle may not come into contact each other. And each vertical probe 205 has a square section, and is inserted into square holes created at opposite positions of the upper and lower insulating boards 201 and 202 so that it may move vertically but does not rotate constituting an anti-rotating structure.

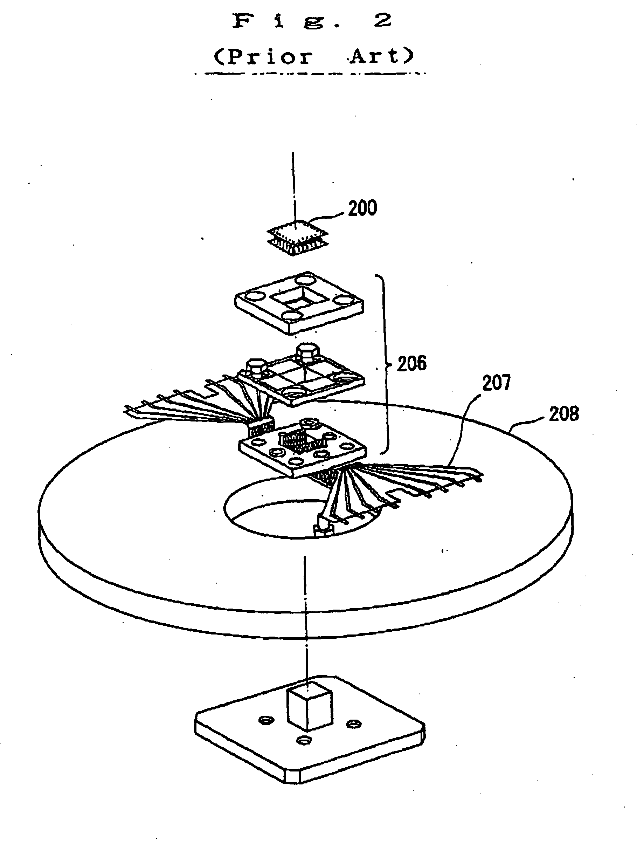

A probing device having such a vertical probe assembly (see, for example, the Patent Reference 2) is constituted as shown in the perspective view of Fig. 2. Specifically, above this vertical probe assembly 200. a semiconductor wafer on which a large number of semiconductor chips to be tested not shown have been formed is set on a wafer stage while the chip pads are kept upside down. On the other hand, below the vertical probe assembly 200, a connecting structure 206 is provided to enter into contact with the vertical probe of this probe assembly 200. This connecting structure 206 is connected with a probe card 208 through a flexible flat cable 207. And the wiring on the connecting structure 206 side of the flexible flat cable 207 is wired by the same narrow pitch as the chip pads. And the end of wiring enables the wiring terminals to come into contact en bloc with the vertical probes of the vertical probe assembly 200. And the wiring pitch interval on the probe card 208 side of the flexible flat cable 207 is extended in such a way that the circuit wiring terminals on the probe card 208 may be soldered.

And the wafer stage (not shown) and the vertical probe assembly 200 can be moved in the X-Y-Z-θ direction. And the vertical probe assembly 200, once positioned and brought into contact en bloc with the wiring terminal of a flexible flat cable provided on the connecting structure 206, need not be moved until the end of the wafer test. Here, the connecting structure 206 plays the role of a socket for connecting with vertical probes by fixing the wiring terminal surface of the flexible flat cable 207 facing upward horizontally. As the details of this connecting structure have already been proposed, the description thereof is omitted here.

The wafer stage is moved in this condition, one of the semiconductor chips is positioned on the vertical probe assembly, and respectively a plurality of chip pad and the upper contact terminals of the vertical probe assembly are connected en bloc. This enables to connect electrically narrow pitch semiconductor chips and probe cards, and drastic improvement of functions as probing device contributes greatly to promote higher integration of semiconductor devices.

As described above, probing devices in which a vertical probe assembly proposed already by the inventors of the present invention can measure even semiconductor chips of a narrowed pad pitch of 45 µm for example.
Moreover, due to the possibility of automatically assembling probes without resorting to soldering, it is possible to mass produce them at low costs, and due to the possibility of vertically contacting en bloc the chip pads, it is possible to uniformly control contact pressure on all the probes. These are important advantages obtained from them.

Nevertheless, this probing device is not different from others in that a plurality of semiconductor chips formed on a semiconductor wafer are tested successively one after another, and it is necessary to move the wafer stage by one tip for each test. On the other hand, the recent trend in the production of semiconductor wafers is for larger diameter (for example, 300 mm in diameter), and the number of semiconductor chips formed on a semiconductor wafer ranges from several tens to several hundreds representing an increasingly higher density. As a result, the time required to test a piece of semiconductor wafer becomes considerable, and the demand is rising for a probing device provided with multiple array of vertical probe assembly (hereinafter referred to as "multiple array vertical probe assembly") capable of testing simultaneously all the semiconductor chips on a wafer without moving the wafer stage. However, in the case of a wafer on which 200 chips each having 100 pads are formed for example, 100 x 200 = 20,000 signal wiring cables will be required for each multiple array vertical probe assembly, and it is difficult to efficiently draw such a number of signal wiring cables from a multiple array vertical probe assembly and connect them to outside testing apparatuses.

On the other hand, if a multiple array vertical probe assembly is to be used for a burn in test, due to a high temperature environment of approximately 12 °C in which it will be placed, the effect of thermal expansion that is not an important issue for testing a chip at a time by a separate row probe assembly will grow in importance, and pitch discrepancy will develop between the pitch of pads formed on a silicon wafer and the pitch of vertical probes planted on insulating board made of a resin film and the like. In particular as the position of vertical probes moves closer to the perimeter of the wafer, the discrepancy of pitch of vertical probes will be cumulated, grow larger and it will become impossible to probe.

Lately a further higher speed and mass en bloc treatment are required. For example, a probe assembly capable of bringing simultaneously contacts into contact with all the pads on a waver with a diameter of 12 inches (wafer of 300 mm in diameter) and of coping with high frequency. With regards to this requirement for higher speed, the following points will be important:
(1) Reduce electric capacity, and for this purpose reduce the area of the probe for the entirety.
(2) Shorten as much as possible the distance between the test circuit and the pads on a wafer.
(3) Reduce noises resulting from magnetic interference generated by probes and wiring cables.
(4) Long distance between contacts and wiring cables opposite thereto.

With regards to wiring lines between probe assemblies and test circuits, the connection of a large number of wiring lines is required. And as a result of narrowing of pitch, a high arraying accuracy of contacts is also required because contacts and pads face each other over a large area.

With regards to a growing number of wiring lines and narrowing of pitch, for example, the number of contacts in a wafer wherein 600 chips having 200 pads each are formed totals as many as 120, 000. It seems possible to solve this number problem by applying a further developed method of the method described in the Japanese Patent Disclosure 2003-075503 to the prior printed wiring board. While the pitch provided by a flat cable is narrow 30 µm pitch, an important issue is how to cope with the wiring of test circuits in view of such narrow pitch contacts. And supposing that a contact force of 5g is applied on each of the 120,000 contacts, a total force of approximately 600 kg will act on the whole probe assembly. Such a force is likely to create a problem of deformation of mechanical parts.

The present invention is made to satisfy these requirements, and its object is to provide an electric signal connecting device with a multiple array structure of vertical probe assembly wherein the problem of thermal expansion and signal wiring are solved and probe assembly used therein so that a plurality of chips may be subjected en bloc at the same time to a probing test or a burn-in test at the time of testing the property of semiconductor chips and other similar circuits which are now becoming increasingly dense as a result of high integration of electronic devices.

US-B1-6326688 discloses a film having a plurality of pins for making electrical test connections with multiple contacts of a semi-conductor device.

US-B1-6330744 discloses an electrical probe test head with electrically conductive pins arranged in a pattern corresponding to the contacts of the device to be tested.

IBM Technical Disclosure Bulletin, volume 17, number 6 of November 1974 discloses how modular probes having contact pins can be arranged in a circular array.

### SUMMARY OF THE INVENTION

According to the invention there is provided an electric signal connecting device comprising:
a probe having a first contact point on one end, a second contact point on the other end and a resiliently deformable part in an intermediate portion of the probe;
said probe making electric connection by entering into contact with a terminal for electric connection created in electric functional elements to be tested; and
a ribbon-shaped resin film for supporting said probe,
   wherein, said probe is formed on or connected to a surface of the resin film in a state being resiliently deformable in the width direction of said resin film;
an opening is formed on a portion of the resin film corresponding to the deformable part of the probe;
the first contact point of said probe protrudes from one longitudinal edge of the resin film so as to contact in use with a terminal of the electric functional elements to be tested;
the second contact point of said probe protrudes from the other longitudinal edge of the resin film so as to contact in use with the terminal of an electric function testing device;
the probe is resiliently deformable to allow said first contact point to move towards the said second contact point so that the opening contracts in response to the force applied to said contact points such that signals may be transmitted and received between the electric functional elements to be tested via said first contact point and the electric function testing device via said second contact point.

### BRIEF DESCRIPTION OF THE DRAWINGS

Fig. 1 is a perspective view of a prior vertical probe assembly;
Fig. 2 is a perspective view of a prior probing device;
Fig. 3 is a block diagram showing the system structure of a prior electric function testing device;
Fig. 4 is a block diagram showing the system structure adapted to multiple wiring and to high speed as a system of the electric function testing device related to the present invention;
Fig. 5 is a perspective view showing the structure of a multiple array vertical probe assembly related to Embodiment 1 of the present invention;
Fig. 6 is a partial perspective view showing the internal structure according to Embodiment 1;
Fig. 7 is a perspective view showing the ribbon-shaped film in the X direction according to Embodiment 2;
Fig. 8 is an enlarged front view of the section A of Fig. 7;
Fig. 9 is a front view showing the ribbon-shaped film in the Y direction according to Embodiment 2;
Fig. 10 is a perspective view showing the unit in the Y direction being assembled according to Embodiment 2;
Fig. 11 is a perspective view of the square bar according to Embodiment 2;
Fig. 12 is a partial perspective view showing the structure of a mounting stand according to Embodiment 2;
Fig. 13 is a partial perspective view showing the structure of a mounting stand according to Embodiment 2;
Fig. 14 is a perspective view of a prop according to Embodiment 2;
Fig. 15 is a perspective view showing the wiring structure of the ribbon-shaped films in the X and Y directions according to Embodiment 1 and 2;

### DESCRIPTION OF THE PREFERRED EMBODIMENTS

Before proceeding to the description of the embodiments of the present invention, an explanation will be given on the current system by which wafer tests representing one of electric function tests in relation to probe cards are being carried out.

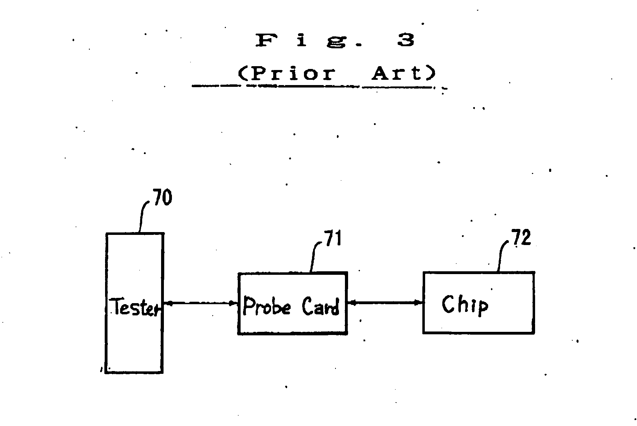

Fig. 3 is a block diagram showing the current system structure of electric function testing devices (in other words an example of the prior arts) in the field of the present invention. In Fig. 3, the code 70 represents a dedicated tester. Generally the dedicated tester 70 used in the current system is large-sized and expensive. The dedicated tester 70 generates electric signals required in the tests of chip 72 and inputs the same into the chip 72 through a probe card 71. The dedicated tester tests will be conduced based on the signals from the chip 72 corresponding to the inputted signals. The number of signal lines from the dedicated tester 70 up to the probe card 71 is approximately 1,100 even when the number of wiring lines for inputting into the chip 72 is approximately 200, and these approximately 1,100 wiring lines enable to cope with a plurality of pad tests.
However, when the number chips 72 has increased very much, for example in the case of coping with 300 chips, the number of wiring lines required will be 60,000 and it will be difficult to send signals by distributing to a large number of chips from approximately 1,100 wiring lines of the dedicated tester. And even if wiring is possible, responses with a large number of wiring lines for high-speed tests will not be effective. Therefore, the current system shown in Fig. 3 can cope with the case of the probes responding at the same time to a limited number of chips.

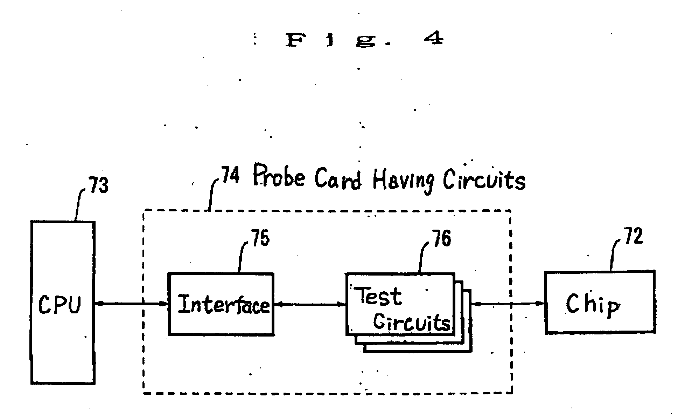

Fig. 4 is a block diagram showing a system structure for coping with a large number of wiring lines and for coping with high speed requirement as a system of electric function testing device according to the present invention. In Fig. 4, the code 73 represents a general-purpose computer, for example a PC. The code 74 represents a probe card having a circuit. It is shown by a broken line. The probe card 74 having a circuit consists of an interface 75 and testing circuits 76. The testing circuits 76 are plural and each of them is started for tests of different purposes. This plurality of testing circuits 76 are not limited to the same functions. The code 72 represent a chip. The general-purpose computer sends testing information for each individual wafer to the interface 75. The interface 75 sends test contents to the testing circuits 76. The testing circuits 76 have testing information corresponding to chips, and send required information to the chips at the time of test. And it also receives and evaluates test result information from the chips 72, and sends the information to the general-purpose computer 73 through the interface 75. And the testing circuits 76 are related one-to-one with chips, and the number of pads in each chip 72 and approximately the same number of testing circuits 76 enable wiring lines to connect with the pads in each chip 72.

### (Embodiment 1)

The following is a detailed description of Embodiment 1 of the probing device of the present invention with reference to drawings. The present embodiment 1 is an effective system when it is applied to the current system shown in Fig. 3, and the integration of wiring lines with probes eliminates the necessity of expensive multilayered board and the like of the prior probe card.

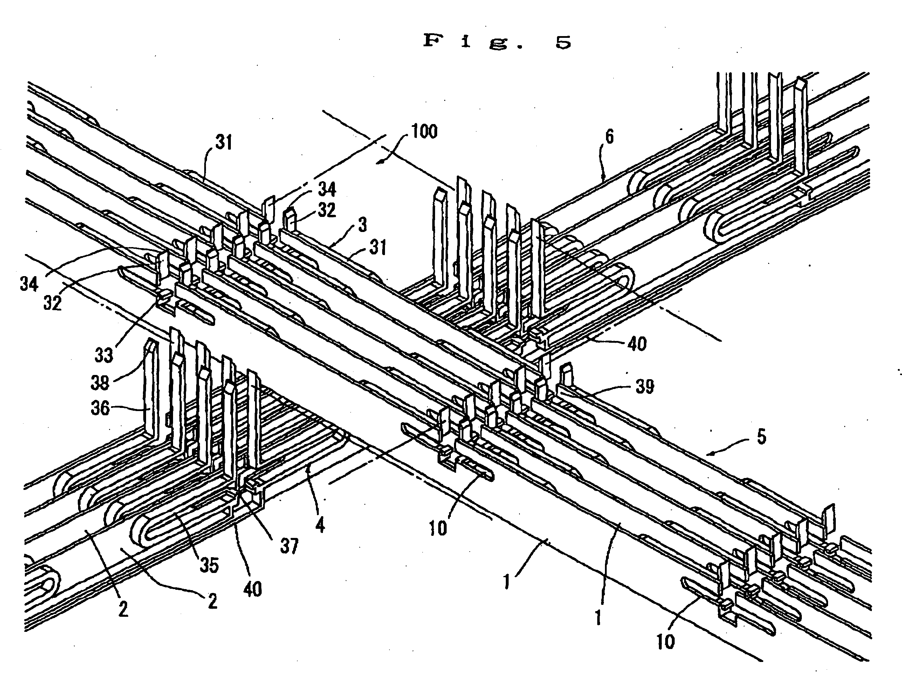

Fig. 5 is a perspective view showing Embodiment 1 of a multiple array vertical probe assembly according to the present invention. The basic structure of the multiple array vertical probe assembly according to the present Embodiment 1 is made up by combining in the grid form a unit in the X direction 5 formed by arranging in the vertical direction a plurality of ribbon-shaped films in the X direction 1 on which a plurality of vertical probes 3 patterned by etching in the longitudinal direction, and, like this unit in the X direction 5, a unit in the Y direction 6 formed by arranging in the vertical direction a plurality of ribbon-shaped films in the Y direction 2 on which a plurality of vertical probes 4 patterned by etching in the longitudinal direction are formed.

Both the ribbon-shaped film in the X direction 1 and the ribbon-shaped film in the Y direction 2 are formed by a ribbon-shaped or belt-shaped insulating film wherein copper and other conductive foils are laminated. And in the present Embodiment 1, the ribbon-shaped film in the X direction 1 and the ribbon-shaped film in the Y direction 2 have basically the same structure.

The vertical probe 3 of the ribbon-shaped film in the X direction 1 includes a curved part 31 formed to the letter U in the longitudinal direction within the surface of the ribbon-shaped film in the X direction 1, upper supporting legs 32 and lower supporting legs 33 extending outward approximately at the right angle at the end of opening of the curved part 31, and a contact point 34 provided at the top of each supporting leg 32.

And the vertical probe 4 of the ribbon-shaped film in the Y direction 2 includes a curved part 35 formed to the letter U in the longitudinal direction within the surface of the ribbon-shaped film in the Y direction 2, upper supporting legs 36 and lower supporting legs 37 extending outward approximately at the right angle at the end of opening of the curved part 35, and a contact point 38 provided at the top of each supporting leg 36.

And the unit in the X direction 5 and the unit in the Y direction 6 are arranged in a vertical positional relationship with the unit in the X direction 5 being arranged above and the unit in the Y direction 6 being placed below and when seen from above they are arranged to be crossing each other. In such an arrangement, in order to make the height of the contact point 34 of the unit in the X direction 5 to agree with the contact point 38 of the unit in the Y direction 6, the length of the upper supporting legs 36 of the vertical probes 3 is set longer than the length of the upper supporting legs 32 of the vertical probes 4. The difference of length of the upper supporting legs 36 and the upper supporting legs 32 is equal to the difference in lever between the unit in the X direction 5 and the unit in the Y direction 6.

In this basic structure, the area of crossing 100 between the unit in the X direction 5 and the unit in the Y direction 6 (the rectangular area enclosed by chain lines with one dot in Fig. 5) represents an area occupied by a semiconductor chip. Taking the area 100 as the center for observation, as a plurality of semiconductor chips can be arranged in succession in the X direction and the Y direction, a plurality of the.areas themselves can be arranged in succession in the X direction and the Y direction when the area 100 is taken as the center of observation. The arrangement of contact points 34 and 38 of the vertical probes 3 and 4 in the area 100 corresponds to the chip pads which are terminals on a semiconductor chip. Hereafter, this structure will be the basis of the description of the embodiments of the probing device of the present invention. Incidentally, the copper foil constituting the ribbon-shaped films 1 and 2 is made up of gold foil, silver foil, or beryllium copper and other highly conductive materials, and the ribbon-shaped films 1 and 2 are made of synthetic resins such as polyimide resin, polyvinyl chloride resin and the like.

In the present Embodiment 1, the wiring lines (or signal lines) 39 and 40 for taking out signals inputted from the contact points 34 and 38 extend from the lower supporting part 33 and 37 of the vertical probes 3 and 4. These wiring lines are also formed by etching like the vertical probes 3 and 4. The wiring lines 39 and 40 extend once downward on the surface of the ribbon-shaped films 1 and 2 from the lower supporting parts 33 and 37 of the vertical probes 3 and 4, are bent approximately at the right angle near the lower end of each ribbon-shaped film 1 and 2 (to face in the longitudinal direction of each ribbon-shaped film 1 and 2), extend along each ribbon-shaped film 1 and 2 and head towards the output terminals. The adoption of such a structure enables to gather the output wiring lines of a plurality of vertical probes 3 and 4 near the lower end of each ribbon-shaped film 1 and 2 and to extend them to the output terminals. Thus, it is possible to simplify the structure of the multiple array vertical probe assembly.

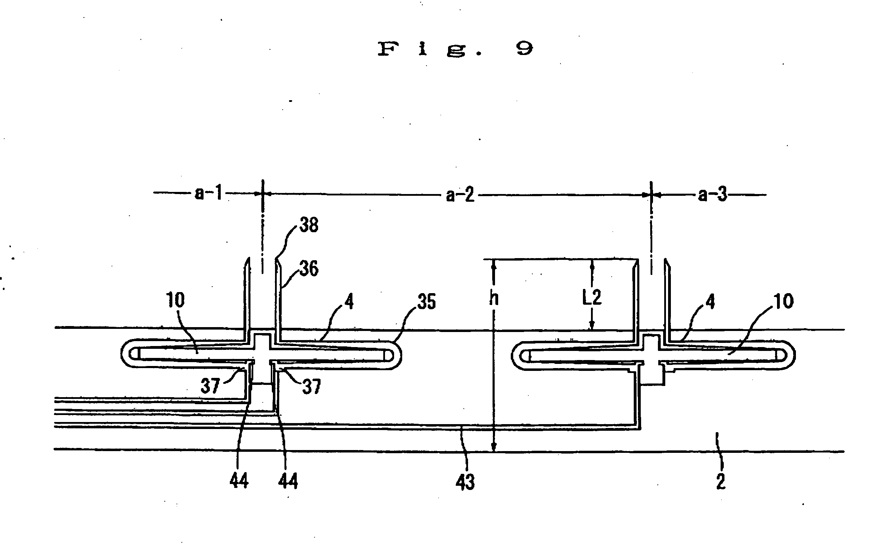

The following is a description of the structure of the ribbon-shaped film in the X direction 1 and the ribbon-shaped film in the Y direction 2 with reference to the front view of Fig. 9. Fig. 9 is essentially used for the description of the ribbon-shaped film in the Y direction 2 in Embodiment 2 of the present invention (described later on). However, this is, in Embodiment 1 of the present invention, almost the same as the structure of the ribbon-shaped film in the X direction 1 and the ribbon-shaped film in the Y direction 2 except for some differences, and is used for similar descriptions.

In the ribbon-shaped film in the X direction 1, an opening 10 is created in the part where a pair of vertical probes 3 are facing against each other. The opening 10 is, as shown in Fig. 9, a nearly T-shaped opening created in the boundary part between adjacent units a (for example a-1 and a-2), and it is created by punching the inner side of curved parts 31 facing each other of the vertical probes 3. As a result, the force applied in the arrow S1 direction to the contact points 34 of the vertical probes 3 acts on the whole curved parts 31 of the vertical probes 3 without being subjected to forces in complicated directions from the resin film by the cutting out of this opening 10 and resiliently deforms the vertical 1 probes 3. In other words, when viewed from the other side, as the basic form of the entire ribbon-shaped film in the X direction 1 is belt-shaped, it deforms freely in response to outside forces applied in the vertical direction to its surface, but it does not deform against outside forces applied in the direction along its surface (either in the longitudinal direction or in the width direction).

However, in the present Embodiment 1, vertical probes 3 are planted on the surface of the ribbon-shaped film in the X direction 1, and the inner side of the curved parts 31 of these vertical probes 3 is punched through to create openings 10. Therefore, in the curved parts 31 of the vertical probes 3, the ribbon-shaped film in the X direction 1 can deform in the surface direction (in the width direction of the surface). Incidentally, the ribbon-shaped film in the X direction 1 is designed basically not to deform in the surface direction in any parts other than the curved parts 31 of the vertical probes 3. Furthermore, on the upper side of the opening 10 the film material of the ribbon-shaped film in the X direction 1 expands continuously. And the same thing can be said on the structure of the ribbon-shaped film in the Y direction 2. The structure described above is the structure of the probe assembly and is the basis of the signal detection operation of the probing devices.

### (Embodiment 2)

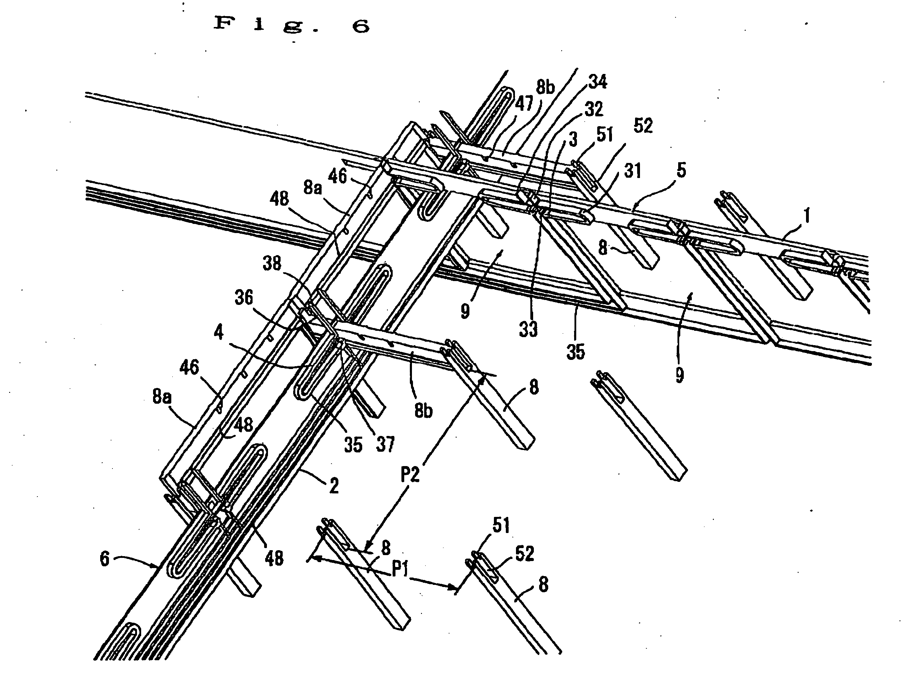

Fig. 6 is a partial perspective view describing the structure of the probing device according to Embodiment 2 of the present invention. Embodiment 2 of the present invention is characterized in that the acting point of contact pressure and the supporting parts subjected to this contact pressure are in the ending position of the curved parts regardless of the number of arrays of multiple arrays and the number of wiring lines, and a good spring characteristic of probes can be obtained. It is also characterized in that the wiring part is behind the supporting part and is unlikely to be affected by the resiliency property of probes, a sufficient space available for electric wiring can be secured, and wiring pattern forms sufficiently taking into account electric property can be obtained. And the probing device using the multiple array vertical probe assembly of the present Embodiment 2 is not constituted by arranging individual probe assemblies in the matrix pattern as in the past, but as Fig. 6 shows a plurality of vertical probes 3 having a curved part are patterned by etching on a ribbon-shaped insulating film made by laminating copper foils, and this patterned ribbon.-shaped film is chosen as the ribbon-shaped film in the X direction 1. Similarly, a plurality of vertical probes 4 are patterned on the ribbon-shaped film, and this patterned ribbon-shaped film is chosen as the ribbon-shaped film in the Y direction 2. Incidentally, the ribbon- shaped films in the X and Y directions 1 and 2 have a plurality of probes and wiring lines on one surface, and the positional relationship that should be arranged on the surface is secured by their respective pattern formation. And the curved parts of adjacent vertical probes facing each other are arranged in the inverse direction so that the arrangement of the contact points of the vertical probes 3 and 4 may correspond with the chip pads on a chip. This arrangement in the inverse direction results in each vertical probe 3 and 4 corresponding to a chip in the wafer being positioned in the area projected for the chip.

A plurality of ribbon-shaped films in the X direction 1 are arranged together to constitute a unit in the X direction 5, a plurality of ribbon-shaped films in the Y direction 2 are arranged together to constitute a unit in the Y direction 6, and this unit in the X direction 5 and the unit in the Y direction 6 are combined in the grid shape to constitute a multiple array vertical probe assembly. Furthermore, this assembly is fixed on a plurality of props 8 planted on the supporting board (not shown) to constitute a probing device.

And unlike the prior art wherein an individual probe assembly corresponded with a chip on the wafer, in the present invention the arrangement of vertical probes 3 and 4 at each crossing position when the units in the X direction and the units in the Y direction are combined corresponds to the pad pitch of a chip. And when the units in the X and Y directions 5 and 6 are combined, the thickness of resin films is reconciled in advance, or is adjusted through spacers, or they are precisely positioned by means of indented indices 8c and 8d on the perimeter of square bars 8a and 8b so that the pitch of the vertical probes 3 and 4 may coincide with the pad pitch of semiconductor chips. The method of arranging closely a plurality of indices 8c and 8d of the present invention for positioning will be described separately.

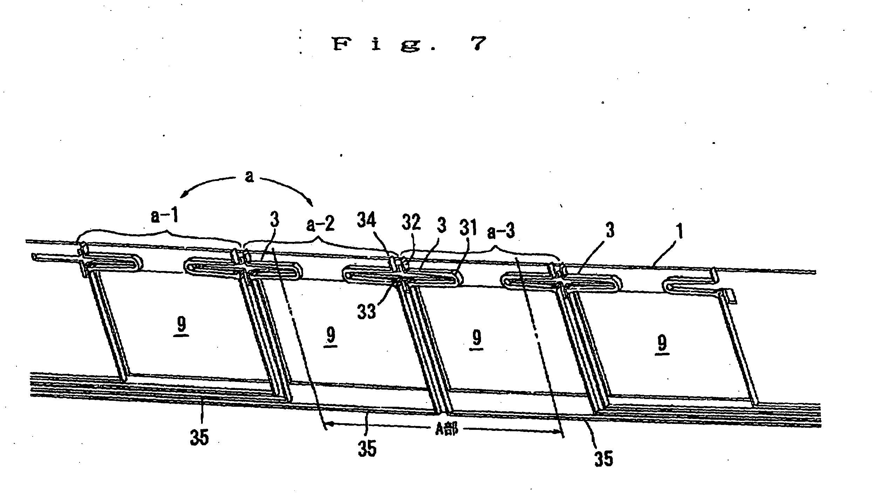

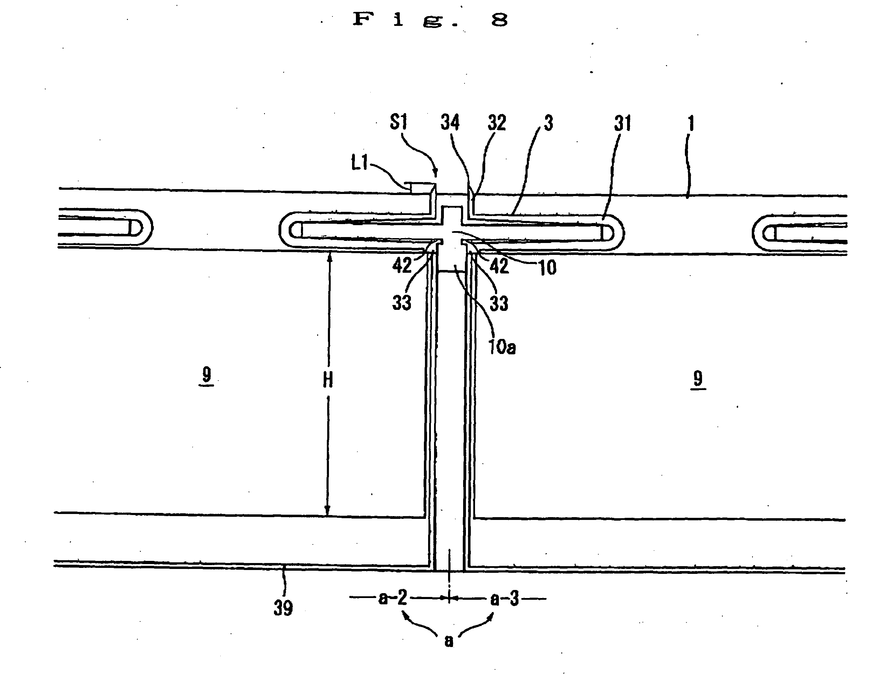

The following is the description in concrete terms on each component of the multiple array vertical probe assembly described above. Fig. 7 is a perspective view of the ribbon-shaped film in the X direction 1 wherein vertical probes 3 are patterned. Fig. 8 is a partially enlarged front view of the ribbon-shaped film in the X direction 1. To begin with, prepare a belt-shaped film made of a polyimide resin or other nonconductive film laminated with beryllium copper foil and other conductive materials and form a ribbon-shaped film in the X direction 1 wherein vertical probes 3 are patterned by etching. The vertical 1 probe 3 has a curved part 31 formed to the U letter in the longitudinal direction on the surface of the ribbon-shaped film in the X direction 1, upper supporting legs 32 and lower supporting legs 33 extending outward nearly at the right angle at the end of the opening of the curved part 31, and the contact points 34 provided at the top of the upper supporting legs 32. In the ribbon-shaped film in the X direction 1, two vertical probes 3 with the back of their curved part 31 arranged to face each other are taken as one unit a, and a plurality of units a are patterned in the longitudinal direction of the ribbon-shaped film in the X direction 1 in the order of a-1, a-2, a-3 .... The number of units a is determined according to the number of chips to be formed on a wafer. At this time, the longitudinal section of the resin film should be removed so that the top part (part where the contact points 34 are formed) of the upper supporting legs 32 of vertical probes 3 protrudes by a length L1 from the edge of the upper long side of the ribbon-shaped film in the X direction 1. The contact point 34 of the vertical probe 3 serves as a probe for contacting the chip pad of the semiconductor chip at the time of probing test, and therefore the top should be as sharp as an edge.

And, the ribbon-shaped film in the X direction 1 has a plurality of first openings 9. The first openings 9 are rectangular punched holes created at the lower part of the vertical probe 3 corresponding to each unit a, and serve to allow the passage of the units in the Y direction 6 as shown in Fig. 6. The opening 10 is, as shown in Fig. 8 (enlarged front view of the section A of Fig. 7), a nearly T-shaped opening created in the boundary part between the adjacent units a (for example a-1 and a-2), and is created by cutting out the inner part of the curved parts 31 facing each other of the vertical probes 3. As a result, the force applied in the arrow S1 direction to the contact point 34 of the vertical probe 3 acts on the whole curved parts 31 of the vertical probes 3 by the creation of this opening 10 without being subjected to forces in complicated directions from the resin film, and resiliently deform the vertical probes 3. In other words, when viewed from another angle, the ribbon-shaped film in the X direction 1 whose basic form in its entirety is belt-shaped freely deforms in response to outside forces applied at the right angle to its surface, but does not deform against outside forces applied in the direction along its surface (whether in the longitudinal direction or in the width direction of the belt). However, in the present invention, due to the plantation of vertical probes 3 on the surface of the ribbon-shaped film in the X direction 1 and the creation of an opening 10 by cutting through the inner part of the curved parts 31 of these vertical probes 3, the ribbon-shaped film in the X direction 1 can deform in the surface direction (in the width direction of the surface) in the section of the curved parts 31 of the vertical probes 3. Incidentally, the ribbon-shaped film in the X direction does not deform in the surface direction in sections other than the curved part 31 of the vertical probe 3. The vertical probe 3 deforms (shown by broken line) by the contact pressure (arrow S.... 1) applied to the contact point 34 part at the time of test, and this deformation generates restoring force, which acts as contact force that enables electric conduction with the contact point 34 between the chip pads on the wafer and the vertical probes 3. And the ribbon-shaped film in the X direction 1 itself functions as a means of maintaining precisely the positional relationship of a plurality of vertical probes 3 arranged in a straight line in the longitudinal direction on its surface rather than contributing to the promotion of dynamic property such as generating the contact pressure of the vertical probes 3. It also plays an important role as a means of positioning in the surface direction of the film of the vertical probes 3 when a plurality of ribbon-shaped films in the X direction 1 are arranged to constitute a unit in the X direction 5. It also functions as an insulating means between adjacent probes or between adjacent wiring lines.

And in the ribbon-shaped film in the X direction 1, as shown in Fig. 8, wiring patterns 39 are formed at the same time as the vertical probes 3 are formed. These wiring patterns 39, totaling two lines respectively from each unit a, specifically one line from two vertical probes 3 included in one unit, extend downward from the vertical probes 3 passing through the range of height of the opening 9, bend downward at the right angle at the lower end of the ribbon-shaped film in the X direction 1 and head in the horizontal direction, forms wiring lines in the area between the lower long side and the opening 9 and extend in the longitudinal direction of the ribbon-shaped film in the X direction 1. The square hole 10a near the center of the opening 10 is a hole for allowing the passage of square bars for positioning when the ribbon-shaped films in the X direction 1 are laid out together as described later on.

The following is a description of the ribbon-shaped film in the Y direction 2 with reference to the front view in Fig. 9. The ribbon-shaped film in the Y direction 2 has a different structure from the ribbon-shaped film in the X direction 1 described above. This is because the ribbon-shaped film in the X direction 1 and the ribbon-shaped film in the Y direction 2 are assembled crosscutting each other in the grid form in such a way that the height of the contact points provided at the top of the vertical probes 3 and 4 may be reconciled. In the first place, the width of the ribbon-shaped film 2 is narrower than that of the ribbon-shaped film 1 because there is no need for a rectangular opening. And the curved part 35 of the vertical probe 4 of the ribbon-shaped film in the Y direction 2 is formed at a position lowered by a fixed distance so that, after the assembly, the curved part 35 of the vertical probes 4 of the ribbon-shaped film in the Y direction 2 may not interfere with the curved part 31 of the vertical probes 3 of the ribbon-shaped film in the X direction 1. For this reason, the longer side part of the ribbon-shaped film 2 is removed so that the contact point 38 may protrude by a length L2 (> L1) from the upper longer side of the ribbon-shaped film in the Y direction 2.

Like the ribbon-shaped film in the X direction 1, as soon as the vertical probe 4 is formed, two wiring patterns 43 respectively from each unit a are formed along the lower longer side of the ribbon-shaped film 2. And the ribbon-shaped film in the Y direction 2 is formed by forming a plurality of this unit a. The cross-shaped opening 10 formed between adjacent units a is formed in the same form as the ribbon-shaped film 1 so that it may have the effect of absorbing the distortions of the vertical probe 4. In any case, width h including the top 42 of the vertical probe 4 of the ribbon-shaped film 2 must be smaller than the dimension of the hole H of the opening 9 of the ribbon-shaped film 1. A square hole 10a is cut out near the center of the opening 10 in the same way as the ribbon-shaped film in the X direction 1.

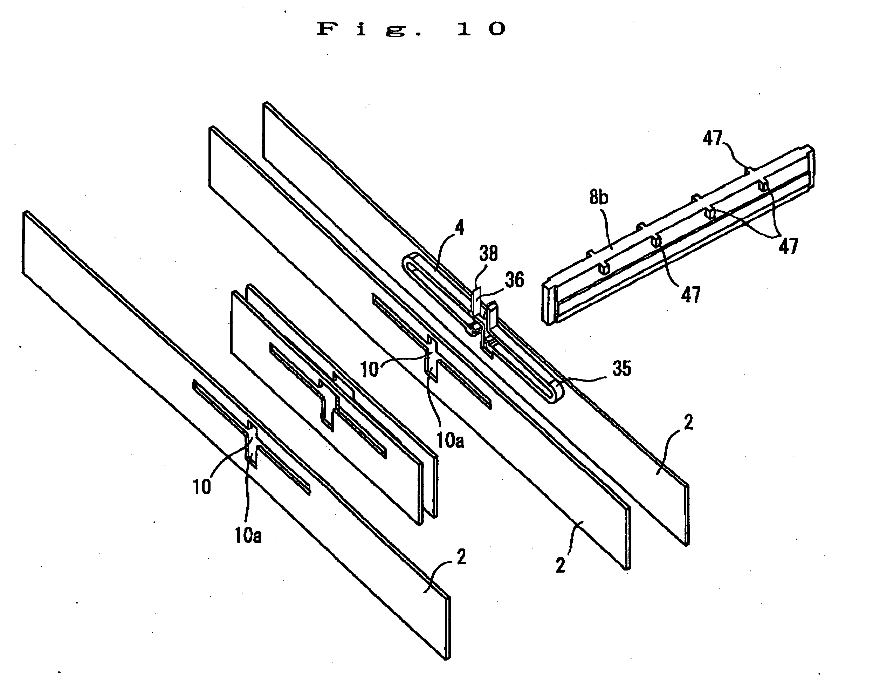

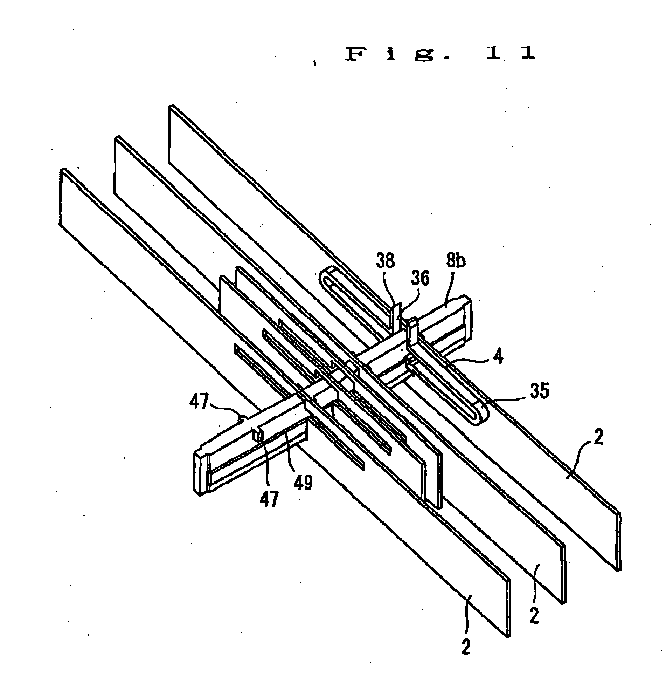

The following is a description of the structure of a multiple array vertical probe assembly formed by assembling units in the X and Y directions 5 and 6 on the supporting board. Fig. 10 is an exploded perspective view describing a unit in the Y direction 6 being assembled by putting together a plurality of ribbon-shaped films in the Y direction 2. This process consists of inserting a square bar 8b having a U-shaped section shown in Fig. 11 into a square hole 10 a of the opening 10 at the right angle to the surface of the ribbon-shaped films in the Y direction 2 and of holding them together in order to prevent the ribbon-shaped films in the Y direction 2 from being dissociated when a plurality of ribbon-shaped films in the Y direction 2 are put together (in other words, put them in order). Each vertical probe 4 has protrusions 44 formed in advance and these protrusions 44 and the square bar 8b are joined together by rendering these protrusions 44 slidable with the square bar 8b and by making the top of the protrusions bump against the side surface of the square bar 8b and each ribbon-shaped film in the Y direction 2 is positioned in the longitudinal direction. Each square bar 8b has a plurality of protrusions 47 at predetermined intervals on its side surface. These protrusions 47 serve to determine the interval of arrangement of a plurality of ribbon-shaped films in the Y direction 2 composing a unit in the Y direction 6. And the arrangement of a plurality of (or it may be one) ribbon-shaped film or films in the Y direction at equal intervals between a protrusion 47 and the following protrusion 47 enables to determine the pitch of contact points 38 in the X direction. A shelf part 49 extending in the longitudinal direction of the square bar 8b by protruding outward from the protruding surface of the protrusion 47 is provided at a position below the protrusion 47 on the side surface of the square bar 8b. This shelf part 49 plays the role of hooking a protrusion 44 formed on the vertical probe 4 of the ribbon-shaped film in the Y direction 2 and supporting the vertical probe 4 from below when the square bar 8b is inserted into the opening 10a of the ribbon-shaped film in the Y direction 2.

Likewise, for the unit in the X direction 5, in order to prevent ribbon-shaped films 1 from dissociating themselves (in other words, to put them in order) as shown in Fig. 6, a square bar 8a with a U-shaped section shown in Fig. 11 is inserted into a square hole 10a of the opening 10 at the right angle of the ribbon-shaped films 1 to hold them together. And as shown in Fig. 8, each vertical probe 3 has a protrusion 42 formed in advance, and these protrusions and the square bar 8a are joined together by rendering these protrusions 42 slidable with the square bar 8a and by bringing the top of the protrusions into contact with the side surface of the square bar 8a by bumping against the latter and thus each ribbon-shaped film in the X direction 1 is positioned in the longitudinal direction. In this way, units in the X and Y directions 5 and 6 are respectively formed as slender blocks. Incidentally, props 8a and 8b are made of non-conductive materials or materials coated with an insulating material. Each square bar 8a has a plurality of protrusions 46 at predetermined intervals on its side surface. These protrusions 46 serve to determine the arrangement interval between a plurality of ribbon-shaped films in the X direction 1 constituting a unit in the X direction 5. And the arrangement of a plurality of (may be one) ribbon-shaped film or films in the X direction 1 at equal intervals between a protrusion 46 and the following protrusion 46 enables to determine the pitch of contact points 34 in the Y direction. A shelf part 48 extending in the longitudinal direction of the square bar 8a by protruding outward further than the protruding surface of the protrusion 46 is provided at a position below the protrusion 46 on the side surface of the square bar 8a. This shelf part 48 plays the role of hooking a protrusion 42 formed on the vertical probe 3 of the ribbon-shaped film in the X direction 1 and supporting the vertical probe 3 from below when the square bar 8a is inserted into the opening 10a of the ribbon-shaped film in the X direction 1.

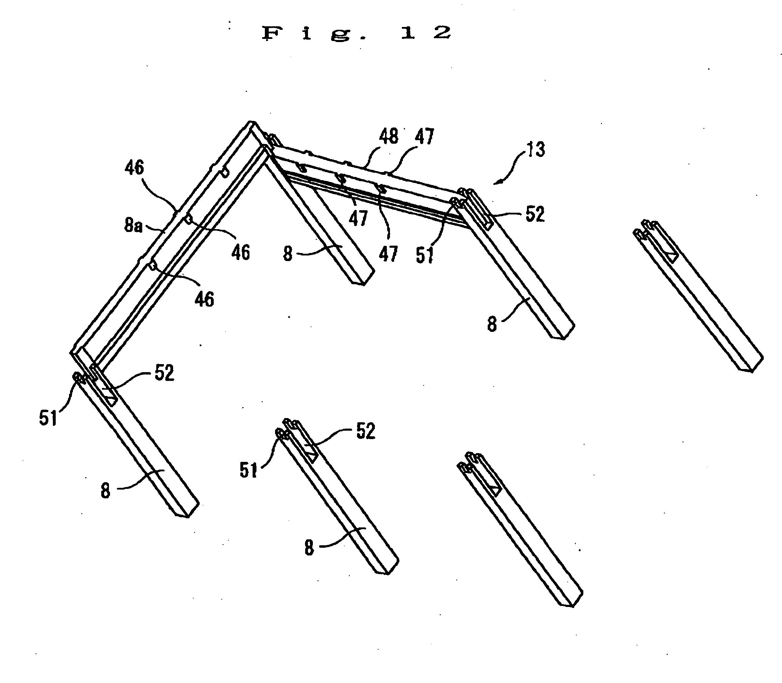

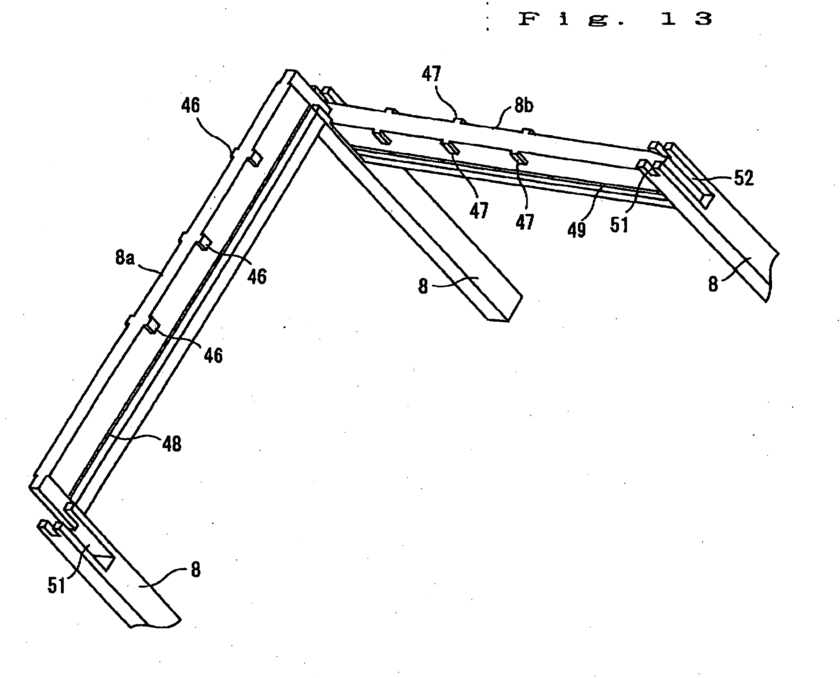

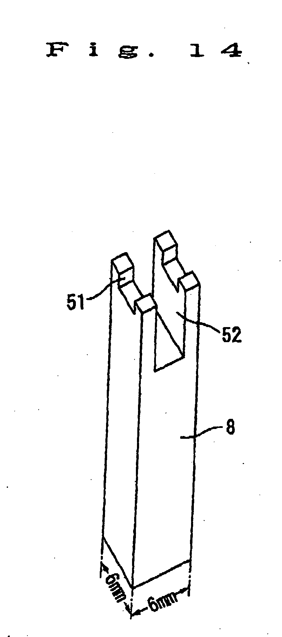

The following is a description of the structure of a multiple array vertical probe assembly formed by assembling units in the X and Y directions on the supporting board. Fig. 12 is a partial perspective view showing a mounting stand serving as the supporting stand 13 of a multiple array vertical probe assembly (showing only the framework part actually in the process of construction) . As this figure shows, the mounting stand 13 on which the units in the X and Y directions 5 and 6 will be mounted consists of a supporting board (not shown. This is a board laid out below the props 8.) and a plurality of props 8 erected on this supporting board. The props 8 are erected separately at four corners of the crossing area 100 of the unit in the X direction 5 with the unit in the Y direction 6, and each of the props 8 is arranged in such a way as to be able to support the unit in the X direction 5 and the unit in the Y direction 6 for the adjacent crossing area 100. The prop 8 is made up of a rod with a rectangular section of a predetermined dimension as shown in Fig. 13 and Fig. 14, and its upper part is notched from the top surface downward and has a first groove 51 and a second groove 52 mutually crossing at the right angle as shown in details in Fig. 14. The first groove 51 is a groove cut relatively shallowly, and the second groove 52 is a groove hollowed out more deeply than the first groove 51. With regard to the first groove 51, the props 8 are erected at a predetermined interval so that the first groove 51 may itself extend in the Y direction. And the first groove 51 is fitted with a square bar 8a (see Fig. 12 and Fig. 13). And with regard to the second groove 52, the props 8 are erected at a predetermined interval so that the second groove 52 may itself extend in the X direction. The second groove 52 is fitted with a square bar 8b (see Fig. 12 and Fig. 13). The supporting board and the prop 8 are, like the square bars 8a and 8b described above, made up of a non-conductive material or a material coated with an insulating material. In particular, the supporting board is preferably made of silicon or a material having a thermal expansion rate similar to that of silicon so that the supporting board may be able to cope with burn-in tests.

The plurality of props 8 are erected in the matrix form on the supporting board so that the pitch of erecting the props 8 in the X direction may be p1 and the pitch in the Y direction may be p2.

So far, the structure of the multiple array vertical probe assembly has been described for each block constituting the same, and the following is the description of the process of assembling these blocks.

To begin with, examples of dimensions of various components will be shown so that they may serve as the yardstick of evaluating the size of the whole multiple array vertical probe assembly. The ribbon-shaped films 1 and 2 as described above consist of, for example, a polyimide film approximately 12 µm thick coated with a beryllium copper foil 20-30 µm thick and on this film the vertical probes 3 and 4 and wiring lines 39 and 43 are patterned. Now, supposing that 10 mm square semiconductor chips are arranged in the X-Y directions on a wafer to be tested, it will be understood that the width of the units in the X and Y directions 5 and 6 respectively consisting of a plurality of ribbon-shaped films 1 and 2 can be approximately 9 mm wide at the maximum. And supposing that each prop 8 erected on the ribbon-shaped film in the X direction 1 adapted to a 10 mm pitch is 0.6 mm square (as shown in Fig. 14), and that the width in the vertical direction for letting a wiring line pass in the longitudinal direction of the ribbon-shaped film in the X direction 1 (dimension of gap between a wiring line and another wiring line) is 0.2 mm, the opening 9 can be 9 mm wide at the maximum. This means that, supposing that a ribbon-shaped film in the X direction 1 is 40 µm thick, 225 ribbon-shaped films in the Y direction can be mathematically arranged within 9 mm and made to pass through the opening 9. However, actually their number will be determined according to the number of pads in a line on a chip.

Regarding the mounting stand 13 shown in Fig. 12, the dimensions of the supporting board are set at nearly the same values as those of the wafer to be tested, and the props 8 are erected according to the number of chips in such a way that four props 8 may represent the area of a chip. And as an example, their pitch is set at p1 = p2 = 10 mm, and the height of the prop 8 is set at a level that removes the possibility of the lower side of the ribbon-shaped film in the X direction 1 touching the supporting board when the units in the X and Y directions 5 and 6 are mounted.

To begin with, a plurality of sets of units in the X direction 5 assembled in advance by inserting successively square bars 8a in the square hole 10a of a plurality of ribbon-shaped films in the X direction 1 are arranged in parallel by adjusting their pitch, and both ends of a square bar 8a are fitted into the first groove 51 of two props 8 erected at intervals in the Y direction, and are mounted between the two props 8. Then, a ribbon-shaped film or films in the Y direction 2 is or are inserted from the Y direction at the right angle into the opening 9 of each film 1 of a unit in the X direction 5. This insertion may be made by a ribbon-shaped film or films in the Y direction 2 one by one at a time, or by a plurality of them corresponding to a unit. When the insertion of ribbon-shaped films 2 is completed, a square bar 8b is inserted successively into the square holes 10a of ribbon-shaped films 2. Both ends of the square bar 8b are fitted into the second groove 52 of two props 8 erected at sparse intervals in the X direction, and are mounted between the two props 8. As the second groove 52 of the prop 8 is cut deeper than the first groove 51, the height of erecting the square bar 8b is set at a lower position than the height of .erecting the square bar 8a. This creates a difference in level between the unit in the X direction 5 and the unit in the Y direction 6 (see Fig. 12 and Fig. 13). In this way, a block of units in the X and Y directions 5 and 6 is assembled in the grid form.

The following is a description of the method of correctly positioning the top of probes at the target positions even if there is a variation in the thickness direction of lamination of the ribbon-shaped film in the Y direction 2 to be laminated with reference to Fig. 10 and Fig. 11. For assembling the unit in the Y direction 6 described in Fig. 10, the ribbon-shaped films in the Y direction 2 are inserted into the opening 9 of a ribbon-shaped film in the X direction 1 to be fixed there, and a square bar 8b is inserted into the opening 10a of the ribbon-shaped films in the Y direction 2. Each square bar 8b has protrusions 47, and when the width dimension of the opening 10a is small, the protrusions 47 serve as stoppers of inserting movement between the ribbon-shaped film in the Y direction 2 and the square bar 8b and cause the square bar 8b to come to a full stop. The positions of the protrusions 47 correspond with the positions for the probe contact point 38 to be positioned, and the presence of a plurality of protrusions 47 in a square bar 8b enables to prevent important positional displacement by correcting the accumulated positional displacement (positional shift in the direction of putting together) resulting from variations in the thickness of the ribbon-shaped film in the Y direction 2 within the range of pitch of the protrusions 47 and to bring the top of probes to positions correctly corresponding to those of the pads in the wafer.

Apart from the problem of preventing the positional shifts described above, when a square bar 8b is inserted into the opening 10a of the ribbon-shaped film 2 in the Y direction 2, a shelf part 49 provided and extending in the longitudinal direction of the square bar 8b comes into contact with a protrusion 44 formed on the vertical probe 4 of the ribbon-shaped film in the Y direction 2 and plays the role of supporting from below the vertical probe 4. And the top of the protrusion 44 and the square bar 8b are joined together when the top of the protrusion 44 strikes against the side surface of the square bar 8b, resulting in the positioning of each ribbon-shaped film in the Y direction 2 in the longitudinal direction.
This action of the top of the protrusion 44 coming into contact with the side surface of the square bar 8b has the effect of not only positioning in the longitudinal direction as mentioned above but also of preventing any positional shifts of the vertical probe 4 due to the thermal expansion of the ribbon-shaped film in the Y direction 2 during a burn-in test.

The above points are similar with regards to the ribbon-shaped film in the X direction 1 and the unit in the X direction 5 constituted by the same.

Then, the block of these units in the X and Y directions 5 and 6 assembled in the grid form is placed on the supporting board. In this way, the units in the X and Y directions are fixed with the supporting board, completing a multiple array vertical probe assembly. In addition, as the units in the X and Y directions 5 and 6 are vertically positioned by the first groove 51 and the second groove 52 formed in the prop 8, it is possible to level the height of the top 32 and 42 of the vertical probes 3 and 4.

According to the present Embodiment 2, as the units in the X and Y directions are fixed on the props in the grid form, even if ribbon-shaped films expand due to differences in temperature, the thermal expansion is absorbed within the unit corresponding to a chip and does not affect the adjacent units, and thus the whole expansion can be contained. As a result, any shift in pitch between the chip pads and the vertical probes is eliminated and it will be possible to measure property by using a multiple array vertical probe assembly.

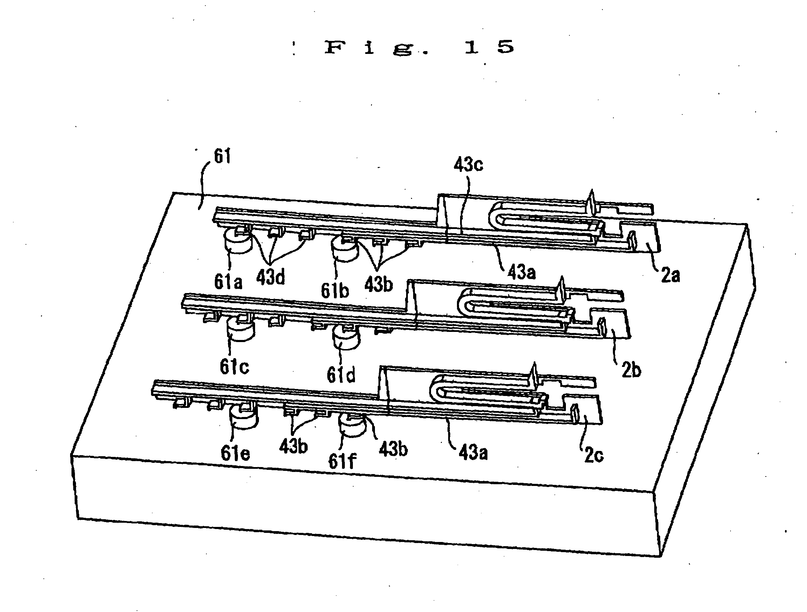

Fig. 15 is a view showing the wiring structure at a film end of the wiring lines 39 and 43 formed on the ribbon-shaped films in the X and Y directions 2. The wiring structure shown in Fig. 15 enables the terminals 61a, 61b, 61c, 61d, 61e and 61f created on the printed wiring board 61 and the terminals for the ribbon-shaped films in the Y direction 2 to arrange the ribbon-shaped films in the Y direction 2 at fine intervals. However, due to coarse intervals between terminals on the printed board 61, the establishment of correspondence one against another between the ribbon-shaped film in the Y direction 2 and the terminals 61a, 61b, 61c, 61d, 61e and 61f of a printed board 61 enables to avoid the necessity of making a large variety of ribbon-shaped films in the Y direction 2. In this case, spring deforming terminals not requiring electric conduction should be insulated. The wiring structure of the present invention provides a means of conducting by contact between the terminals on the printed board 61 and the terminals of the ribbon-shaped films in the Y direction 2 without soldering. The wiring 43a includes a plurality of spring deformable terminals 43b (three terminals in the example of Fig. 15). The wiring 43c also includes a plurality of spring deformable terminals 43d. Even if the intervals among the terminals 61a, 61b, 61c, 61d, 61e and 61f on the printed board 61 are coarse, resilient terminals of a plurality of terminals 43b to 43d of the ribbon-shaped films in the Y direction 2 arranged by a fine pitch are used for electric conduction. Since they are resilient terminals, a pressure applied from above (not shown) on.the ribbon-shaped films in the Y direction brings the resilient terminals into contact with the terminals on the printed board with a nearly uniform contact pressure.

According to the present invention, fine vertical probes and wiring patterns can be easily processed by etching a generally used copper foil laminated resin film, and a multiple array vertical probe assembly can be easily made by combining in the grid form in the X and Y directions these units made by arranging a plurality of the resin films cut out in the ribbon shape. In this way, it will be possible to measure by probing en bloc multiple chips formed on a semiconductor wafer of a larger diameter, and significant contribution can be foreseen in the field of semiconductor field with more emphasis on miniaturization as higher integration of IC chips progresses.

The present invention has been described on the basis of preferable embodiments shown in figures. However, it is obvious that any one skilled in the art can easily change or modify the present invention, and such changed or modified parts are included in the scope of the present claims. In particular, the present invention is effective when it is used for testing the circuit of a plurality of semiconductor chips formed on a semiconductor wafer in the manufacturing process of LSI and other similar electronic devices. In addition, the present invention can be used for testing the function of electronic functional elements including the circuit of a large variety of electronic devices including liquid crystals and the like.

## Claims

1. An electric signal connecting device comprising:
a probe (3) having a first contact point (34) on one end, a second contact point (39) on the other end and a resiliently deformable part (35) in an intermediate portion of the probe;
said probe making electric connection by entering into contact with a terminal for electric connection created in electric functional elements to be tested; and
a ribbon-shaped resin film (1) for supporting said probe (3),
wherein, said probe is formed on or connected to a surface of the resin film in a state being resiliently deformable in the width direction of said resin film;
an opening (10) is formed on a portion of the resin film corresponding to the deformable part of the probe (3);
the first contact point (34,38) of said probe protrudes from one longitudinal edge of the resin film (1) so as to contact in use with a terminal of the electric functional elements to be tested;
the second contact point (39) of said probe protrudes from the other longitudinal edge of the resin film so as to contact in use with the terminal of an electric function testing device;
the probe (3) is resiliently deformable to allow said first contact point (34;38) to move towards the said second contact point (39) so that the opening (10) contracts in response to the force applied to said contact points such that signals may be transmitted and received between the electric functional elements to be tested via said first contact point (34) and the electric function testing device via said second contact point (39).

2. The connecting device according to claim 1 wherein the probe (3) is made of thin metal plate and is joined integrally to the surface of the resin film (1) by being adhered thereon.

3. The connecting device according to claim 1 wherein the film is a copper foil laminated resin film and said probe created thereon by etching.

4. The connecting device of any of claims 1-3 and having a plurality of probes (3) on said film (1).

5. A probing device for establishing electric connection between a testing device and a plurality of semiconductor chips to be tested formed on a semiconductor wafer through probes by bringing the probes into contact with the semiconductor chips to be tested, the probing device comprising:
a plurality of connecting devices according to claim 4 arranged mutually orthogonally in an X direction and in a Y direction in an overlying grid form and on a supporting board, so that in use the probes in the X direction and in the Y direction are brought into contact en bloc with all the pads of chips to be tested,
the films being arranged in such a way that the respective first contact points (34;38) in the X and Y directions project by a different amount from the film's upper edge (L1,L2) so as to be flush at the tips thereof to permit simultaneous en bloc contact in use,

6. The probing device according to claim 5, wherein crossing positions of the connecting devices in the X direction and in the Y direction correspond one to one with one or more semiconductor chips to be tested formed on a semiconductor wafer, and the films in the X direction and in the Y direction are spaced in the Z direction at the crossing positions and do not interfere with each other.

7. The probing device according to claim 5, wherein an arrangement of said probes arranged at each crossing position in the X direction and in the Y direction is connected to a wiring line at the respective ends of the resiliently deformable part, said arrangement being held together by means comprising a square section bar (8b) engaged in square holes (10a).

8. The probing device according to claim 5, wherein said devices in the X direction and in the Y direction comprise a curved part (31,35) created on a copper foil laminated resin film and a wiring line pattern connected thereto by etching.

9. The probing device according to claim 5, wherein the curved parts (31,35) of adjacent probes on the same film in the X or Y directions face oppositely on a respective film.

10. The probing device according to claim 5, wherein said films in one of the X and Y directions have a second opening (9) cut out at equal intervals in the longitudinal direction for allowing the ribbon-shaped film in the Y directions to pass orthogonally.

11. The probing device of claim 5 wherein said films in the X and Y directions have a square hole (10a) in the region of the respective opening (10); and a respective square bar (8b) is inserted through the square holes (10a) in the X and Y directions, each square bar having a plurality of protrusions (47) at pre-determined intervals on the side surface to determine the lateral spacing of adjacent films and hence the pitch of the first contact points (33,38).

12. The probing device of claim 11 wherein a plurality of probes (3) are provided on each film (1) in the X and Y directions.

## Patentansprüche

1. Elektrische Signalverbindungsvorrichtung, mit:
einem Messfühler (3), der einen ersten Kontaktpunkt (34) an einem Ende, einen zweiten Kontaktpunkt (39) an dem anderen Ende und einen elastisch deformierbaren Teil (35) in einem Zwischenabschnitt des Messfühlers aufweist;
wobei der Messfühler eine elektrische Verbindung durch Kontaktieren mit einem Anschluss für eine elektrische Verbindung, erzeugt in zu testenden elektrischen funktionalen Elementen, hestellt; und
einer bandförmigen Harzschicht (1) zum Stützen des Messfühlers (3);
wobei der Messfühler auf oder mit einer Oberfläche der Harzschicht in einem elastisch deformierbaren Zustand in der Breiterichtung der Harzschicht gebildet bzw. verbunden ist,
wobei eine Öffnung (10) auf einem Abschnitt der Harzschicht entsprechend dem deformierbaren Teil des Messfühlers (3) gebildet ist;
wobei der erste Kontaktpunkt (34, 38) des Messfühlers von einer longitudinalen Kante der Harzschicht (1) hervorragt, um in Gebrauch mit einem Anschluss der zu testenden elektrischen funktionalen Elemente zu kontaktieren;
wobei der zweite Kontaktpunkt (39) des Messfühlers von der anderen longitudinalen Kante der Harzschicht hervorragt, um in Gebrauch mit dem Anschluss einer elektrischen Funktionstestvorrichtung zu kontaktieren;
wobei der Messfühler (3) elastisch deformierbar ist, um dem ersten Kontaktpunkt (34; 38) zu ermöglichen, sich in Richtung des zweitens Kontaktpunktes (39) zu bewegen, so dass die Öffnung (10) im Ansprechen auf die an die Kontaktpunkte angelegte Kraft derart kontrahiert, dass Signale zwischen den zu testenden elektrischen funktionalen Elementen über den ersten Kontaktpunkt (34) und der elektrischen Funktionstestvorrichtung über den zweiten Kontaktpunkt (39) übertragen und empfangen werden können.

2. Verbindungsvorrichtung nach Anspruch 1, wobei der Messfühler (3) aus einer dünnen Metallplatte hergestellt ist und ganz an der Oberfläche der Harzschicht (1) angefügt ist, **dadurch** dass er darauf angeklebt ist.

3. Verbindungsvorrichtung nach Anspruch 1, wobei die Schicht eine mit einer Kupferfolie laminierte Harzschicht ist und der Messfühler durch Ätzen darauf erzeugt ist.

4. Verbindungsvorrichtung nach einem der Ansprüche 1 bis 3, mit einer Vielzahl von Messfühlern (3) auf der Schicht (1).

5. Messfühlvorrichtung zum Aufbauen einer elektrischen Verbindung zwischen einer Testvorrichtung und einer Vielzahl von auf einem Halbleiterwafer gebildeten zu testenden Halbleiterchips mit Messfühlern durch Kontaktieren der Messfühler mit den zu testenden Halbleiterchips, wobei die Messfühlvorrichtung Folgendes aufweist:
eine Vielzahl von Verbindungsvorrichtungen nach Anspruch 4, die gegenseitig orthogonal in einer X-Richtung und in einer Y-Richtung in einer darüberliegenden Gitterform und auf einer Stützplatine angeordnet sind, so dass in Gebrauch die Messfühler in der X-Richtung und in der Y-Richtung mit allen Kontaktstellen der zu testenden Chips en bloc in Kontakt gebracht werden,
wobei die Schichten derart angeordnet sind, dass die jeweiligen ersten Kontaktpunkte (34; 38) in den X- und Y-Richtungen um einen unterschiedlichen Betrag aus der oberen Kante (L1, L2) der Schicht herausragen, um an den Enden davon bündig zu sein, um in Gebrauch eine gleichzeitige Kontaktierung en bloc zuzulassen.

6. Messfühlvorrichtung nach Anspruch 5, wobei Kreuzungspositionen der Verbindungsvorrichtungen in der X-Richtung und in der Y-Richtung eins-zu-eins einem oder mehreren auf einem Halbleiterwafer gebildeten zu testenden Halbleiterchips entsprechen, und die Schichten in der X-Richtung und in der Y-Richtung an den Kreuzungspositionen in der Z-Richtung beabstandet sind und nicht miteinander interferieren.

7. Messfühlvorrichtung nach Anspruch 5, wobei eine Anordnung der an jeder Kreuzungsposition in der X-Richtung und in der Y-Richtung angeordneten Messfühler mit einer Leiterbahn an den jeweiligen Enden der elastisch deformierbaren Teile verbunden ist, wobei die Anordnung durch eine Einrichtung zusammengehalten wird, die einen quadratischen Profilstab (8b) aufweist, der in quadratischen Löchern (10a) eingelegt ist.

8. Messfühlvorrichtung nach Anspruch 5, wobei die Vorrichtungen in der X-Richtung und in der Y-Richtung einen gekrümmten Teil (31, 35) aufweisen, der auf einer mit einer Kupferfolie laminierten Harzschicht erzeugt ist und ein Leiterbahnmuster durch Ätzen daran verbunden ist.

9. Messfühlvorrichtung nach Anspruch 5, wobei die gekrümmten Teile (31, 35) von benachbarten Messfühlern auf derselben Schicht in den X- oder Y-Richtungen auf einer jeweiligen Schicht gegenüberliegen.

10. Messfühlvorrichtung nach Anspruch 5, wobei die Schichten in einer der X- und Y-Richtungen eine zweite Öffnung (9) aufweisen, die in gleichen Intervallen in der longitudinalen Richtung herausgeschnitten ist, um der bandförmigen Schicht zu ermöglichen, in der Y-Richtung orthogonal hindurch zu verlaufen.

11. Messfühlvorrichtung nach Anspruch 5, wobei die Schichten in den X- und Y-Richtungen ein quadratisches Loch (10a) in dem Bereich der jeweiligen Öffnung (10) aufweisen; und ein jeweiliger Vierkant (8b) durch die quadratischen Löcher (10a) in die X- und Y-Richtungen eingefügt ist, wobei jeder Vierkant eine Vielzahl von Überständen (47) in vorbestimmten Intervallen auf der Seitenoberfläche aufweist, um die laterale Beabstandung von benachbarten Schichten und somit den Abstand der ersten Kontaktpunkte (33, 38) zu bestimmen.

12. Messfühlvorrichtung nach Anspruch 11, wobei eine Vielzahl von Messfühlern (3) auf jeder Schicht (1) in den X- und Y-Richtungen bereitgestellt ist.

## Revendications

1. Dispositif de connexion de signal électrique comprenant :
une pointe (3) ayant un premier point de contact (34) à une extrémité, un deuxième point de contact (39) à l'autre extrémité et une partie élastiquement déformable (35) dans une partie intermédiaire de la pointe ;
ladite pointe réalisant une connexion électrique en entrant en contact avec une borne de connexion électrique créée dans des éléments fonctionnels électriques devant être testés ; et
un film de résine en forme de ruban (1) pour supporter ladite pointe (3),
dans lequel ladite pointe est formée sur ou reliée à une surface du film de résine dans un état qui est élastiquement déformable dans le sens de la largeur dudit film de résine ;
une ouverture (10) est formée sur une partie du film de résine correspondant à la partie déformable de la pointe (3) ;
le premier point de contact (34, 38) de ladite pointe fait saillie à partir d'un bord longitudinal du film de résine (1) de manière à entrer en contact en utilisation avec une borne des éléments fonctionnels électriques devant être testés ;
le deuxième point de contact (39) de ladite pointe fait saillie à partir de l'autre côté longitudinal du film de résine de manière à entrer en contact en utilisation avec la borne d'un dispositif d'essai de fonction électrique ;
la pointe (3) est élastiquement déformable pour permettre audit premier point de contact (34 ; 38) de se déplacer vers ledit deuxième point de contact (39) de manière que l'ouverture (10) se contracte en réponse à la force appliquée auxdits points de contact de sorte que des signaux puissent être émis et reçus entre les éléments fonctionnels électriques devant être testés par ledit premier point de contact (34) et le dispositif d'essai de fonction électrique par ledit deuxième point de contact (39).

2. Dispositif de connexion selon la revendication 1, dans lequel la pointe (3) est faite d'une fine plaque de métal et est reliée d'un seul tenant à la surface du film de résine (1) en étant collée dessus.

3. Dispositif selon la revendication 1, dans lequel le film est un film de résine revêtu d'une feuille de cuivre et ladite pointe est créée dessus par gravure.

4. Dispositif de connexion selon l'une quelconque des revendications 1 à 3 et ayant une pluralité de pointes (3) sur ledit film (1).

5. Dispositif de contrôle pour établir une connexion électrique entre un dispositif d'essai et une pluralité de puces à semi-conducteurs devant être testées formées sur une tranche de semi-conducteur par des pointes en amenant les pointes en contact avec les puces à semi-conducteurs devant être testées, le dispositif de contrôle comprenant :
une pluralité de dispositifs de connexion selon la revendication 4 agencés mutuellement de manière orthogonale dans une direction X et dans une direction Y dans une forme de grille chevauchante et sur une carte de support, de sorte qu'en utilisation les pointes dans la direction X et dans la direction Y soient mises en contact en bloc avec tous les pastilles de puces devant être testées,
les films étant agencés d'une façon telle que les premiers points de contact respectifs (34,38) dans les directions X et Y fassent saillie d'un degré différent du bord supérieur du film (L1, L2) de manière à affleurer les bords de celui-ci pour permettre un contact en bloc simultané en utilisation.

6. Dispositif de contrôle selon la revendication 5, dans lequel des positions de croisement des dispositifs de connexion dans la direction X et dans la direction Y correspondent une à une avec une ou plusieurs puces à semi-conducteurs devant être testées formées sur une tranche de semi-conducteur, et les films dans la direction X et dans la direction Y sont espacés dans la direction Z aux positions de croisement et n'interfèrent pas les uns avec les autres.

7. Dispositif de contrôle selon la revendication 5, dans lequel un agencement desdites pointes agencées à chaque position de croisement dans la direction X et dans la direction Y est relié à une ligne de câblage aux extrémités respectives de la partie élastiquement déformable, ledit agencement étant maintenu par des moyens comprenant une barre de section carrée (8b) mise en prise dans des trous carrés (10a).

8. Dispositif de contrôle selon la revendication 5, dans lequel lesdits dispositifs dans la direction X et dans la direction Y comprennent une partie incurvée (31, 35) créée sur un film de résine revêtu d'une feuille de cuivre et une structure de ligne de câblage reliée à celui-ci par gravure.

9. Dispositif de contrôle selon la revendication 5, dans lequel les parties incurvées (31, 35) des pointes adjacentes sur le même film dans les directions X et Y se font face de manière opposée sur un film respectif.

10. Dispositif de contrôle selon la revendication 5, dans lequel lesdits films dans l'une des directions X et Y possèdent une deuxième ouverture (9) découpée à intervalles réguliers dans la direction longitudinale pour faire passer les films en forme de ruban dans les directions Y de manière orthogonale.

11. Dispositif de contrôle selon la revendication 5, dans lequel lesdits films dans les directions X et Y possèdent un trou carré (10a) dans la région de l'ouverture respective (10) ; et une barre carrée respective (8b) est insérée à travers les trous carrés (10a) dans les directions X et Y, chaque barre carrée ayant une pluralité de saillies (47) à des intervalles prédéterminés sur la surface latérale pour déterminer l'espacement latéral des films adjacents et ainsi le pas des premiers points de contact (33, 38).

12. Dispositif de contrôle selon la revendication 11, dans lequel une pluralité de pointes (3) sont prévues sur chaque film (1) dans les directions X et Y.
